# EUROPEAN PATENT APPLICATION

(11) **EP 4 773 169 A1**
(43) Date of publication of application: **08.07.2026**
(21) Application number: 24859163.8
(22) Date of filing: 04.07.2024
(51) Int. Cl.: H01L 21/304

(54) **SUBSTRATE PROCESSING METHOD AND SUBSTRATE PROCESSING DEVICE**

(30) Priority: 29.08.2023 JP 2023138879
(71) Applicant: SCREEN Holdings Co., Ltd., Kyoto-shi, Kyoto 602-8585 (JP)
(72) Inventor: TSUKAHARA, Ryuta, Kyoto-shi, Kyoto 602-8585 (JP); TANAKA, Tomoya, Kyoto-shi, Kyoto 602-8585 (JP); INABA, Masaki, Kyoto-shi, Kyoto 602-8585 (JP); HIGUCHI, Ayumi, Kyoto-shi, Kyoto 602-8585 (JP)
(74) Representative: Kilian Kilian & Partner mbB
(86) International application number: PCT/JP2024/024304
(87) International publication number: WO 2025/047118

(57) **Abstract**

A substrate processing method includes a liquid film forming step of supplying a sublimable substance-containing liquid containing a sublimable substance to a front surface of a substrate W to form a liquid film of the sublimable substance-containing liquid on the front surface of the substrate W, a solidified film forming step of changing the liquid film of the sublimable substance-containing liquid into a solidified film SF containing the sublimable substance on the front surface of the substrate W, a sublimating step of sublimating the solidified film SF to remove the solidified film SF from the front surface of the substrate W, and a humidity increasing step of increasing humidity of an atmosphere in contact with the substrate W after sublimation of the solidified film SF is started.

## Description

### Related Application

This application claims the benefit of priority to Japanese Patent Application No. 2023-138879 filed on August 29, 2023, the entire contents of which are hereby incorporated herein by reference.

### Technical Field

The present invention relates to a substrate processing method and a substrate processing apparatus that process substrates. The substrate includes a semiconductor wafer, a substrate for a FPD (Flat Panel Display) such as a liquid crystal display and an organic EL (electroluminescence) display, a substrate for an optical disc, a substrate for a magnetic disc, a substrate for a magneto-optical disc, a substrate for a photomask, a ceramic substrate, a substrate for a solar cell, and the like, for example.

### Background Art

Patent literature 1 discloses that when a frozen body is sublimated and removed from the pattern-formed surface of a substrate, the organic substances precipitated on the frozen body are removed using ultraviolet rays or ozone gas.

### Citation List

### Patent Literature

Patent Literature 1: JP 2018-110199 A

### Summary of Invention

### Technical Problem

However, in the substrate processing method and the substrate processing apparatus described in Patent Literature 1, the organic substances cannot be removed without using ultraviolet rays or ozone gas.

At least one embodiment of the present invention provides a substrate processing method and a substrate processing apparatus capable of removing organic substances generated when a solidified film containing a sublimable substance is sublimated, without using ultraviolet rays or ozone gas.

### Solution to Problem

An embodiment of the present invention provides a substrate processing method including a liquid film forming step of supplying a sublimable substance-containing liquid containing a sublimable substance to a front surface of a substrate to form a liquid film of the sublimable substance-containing liquid on the front surface of the substrate, a solidified film forming step of changing the liquid film of the sublimable substance-containing liquid into a solidified film containing the sublimable substance on the front surface of the substrate, a sublimating step of sublimating the solidified film to remove the solidified film from the front surface of the substrate, and a humidity increasing step of increasing humidity of an atmosphere in contact with the substrate after sublimation of the solidified film is started.

In the embodiment, at least one of the following features may be added to the substrate processing method.

The humidity increasing step includes a step of increasing humidity of an atmosphere in contact with an entirety of the front surface of the substrate after the sublimation of the solidified film is started.

The humidity increasing step includes a step of increasing the humidity of the atmosphere in contact with the substrate after the sublimation of the solidified film is started and before the sublimation of the solidified film ends.

The humidity increasing step includes a step of discharging a humidifying gas having humidity higher than that of the atmosphere in contact with the substrate toward the front surface of the substrate after the sublimation of the solidified film is started.

The humidity increasing step includes a step of discharging the humidifying gas toward the front surface of the substrate in a state in which a shielding member that is movable in parallel in a direction perpendicular to the front surface of the substrate between a proximity position where the shielding member faces the front surface of the substrate and a standby position where the shielding member faces the front surface of the substrate at a position further away from the substrate than when the shielding member is positioned at the proximity position is positioned at the proximity position after the sublimation of the solidified film is started.

The humidity increasing step includes a step of discharging the humidifying gas toward the front surface of the substrate in a state in which a shielding member that is movable in parallel in a direction perpendicular to the front surface of the substrate between a proximity position where the shielding member faces the front surface of the substrate and a standby position where the shielding member faces the front surface of the substrate at a position further away from the substrate than when the shielding member is positioned at the proximity position is positioned at the standby position after the sublimation of the solidified film is started.

The humidity increasing step includes a step of moving a humidifying gas nozzle that discharges the humidifying gas toward the front surface of the substrate in a state where the shielding member is positioned at the standby position after the sublimation of the solidified film is started.

The humidity increasing step includes a step of discharging water toward a shielding member from a position opposite to the substrate with respect to the shielding member while rotating the shielding member about a rotational axis passing through a central portion of the shielding member in a state in which the shielding member that is movable in parallel in a direction perpendicular to the front surface of the substrate between a proximity position where the shielding member faces the front surface of the substrate and a standby position where the shielding member faces the front surface of the substrate at a position further away from the substrate than when the shielding member is positioned at the proximity position is positioned at the standby position after the sublimation of the solidified film is started.

A typical example of the water discharged toward the shielding member is pure water. As long as the liquid contains water as a main component (when the concentration of water is, for example, 99% or more), the water may contain a substance other than water.

The solidified film forming step includes a step of changing the liquid film of the sublimable substance-containing liquid into the solidified film on the front surface of the substrate while supplying an inert gas between the substrate and the shielding member in a state where the shielding member is positioned at the proximity position.

The sublimable substance is cyclohexanone oxime.

Another embodiment of the present invention provides a substrate processing apparatus including a substrate holder that holds a substrate, a sublimable substance-containing liquid nozzle that supplies a sublimable substance-containing liquid containing a sublimable substance to a front surface of the substrate held by the substrate holder and thereby forms a liquid film of the sublimable substance-containing liquid on the front surface of the substrate, a gas nozzle that discharges a gas toward the front surface of the substrate held by the substrate holder, a spin motor that rotates the substrate holder about a rotational axis passing through a central portion of the substrate held by the substrate holder and thereby rotates the substrate held by the substrate holder, a humidifier that increases humidity of an atmosphere in contact with the substrate, and a controller that causes at least one of the gas nozzle and the spin motor to perform at least one of supply of the gas to the substrate and rotation of the substrate and thereby changes the liquid film of the sublimable substance-containing liquid into a solidified film containing the sublimable substance on the front surface of the substrate, and then sublimates the solidified film, and causes the humidifier to increase the humidity of the atmosphere in contact with the substrate after sublimation of the solidified film is started. At least one of the above-described features regarding the substrate processing method may be added to the substrate processing apparatus.

The above and other objects, features, and advantages of the present invention will become more apparent from the following detailed description of the embodiments with reference to the attached drawings.

### Brief Description of Drawings

[FIG. 1A] a schematic plan view showing a layout of a substrate processing apparatus according to an embodiment of the present invention.
[FIG. 1B] a schematic side view of the substrate processing apparatus.
[FIG. 2] a schematic view of an interior of a processing unit provided in the substrate processing apparatus when viewed horizontally.
[FIG. 3] a schematic view of the interior of the processing unit when viewed from above.
[FIG. 4] a schematic view of a gas nozzle when viewed horizontally.
[FIG. 5] a schematic cross-sectional view showing a vertical cross-section of a shielding member.
[FIG. 6] a block diagram showing an electrical arrangement of the substrate processing apparatus.
[FIG. 7] a process chart for describing an example of processing of a substrate performed by the substrate processing apparatus.
[FIGS. 8A-E] schematic cross-sectional views of the substrate.
[FIG. 9A] a schematic view for explaining Flow 1 which is a first example of a flow from the start of a sublimating step to the end of a humidity increasing step.
[FIG. 9B] a schematic view for explaining Flow 1.
[FIG. 9C] a schematic view for explaining Flow 1.
[FIG. 10A] a schematic view for explaining Flow 2 which is a second example of the flow from the start of the sublimating step to the end of the humidity increasing step.
[FIG. 10B] a schematic view for explaining Flow 2.
[FIG. 10C] a schematic view for explaining Flow 2.
[FIG. 11A] a schematic view for explaining Flow 3 which is a third example of the flow from the start of the sublimating step to the end of the humidity increasing step.
[FIG. 11B] a schematic view for explaining Flow 3. Description of Embodiments

In the following description, unless otherwise specified, it is to be understood that the atmospheric pressure inside a substrate processing apparatus 1 is kept at atmospheric pressure (e.g., one atmospheric pressure or a value in its vicinity) inside a clean room in which the substrate processing apparatus 1 is installed.

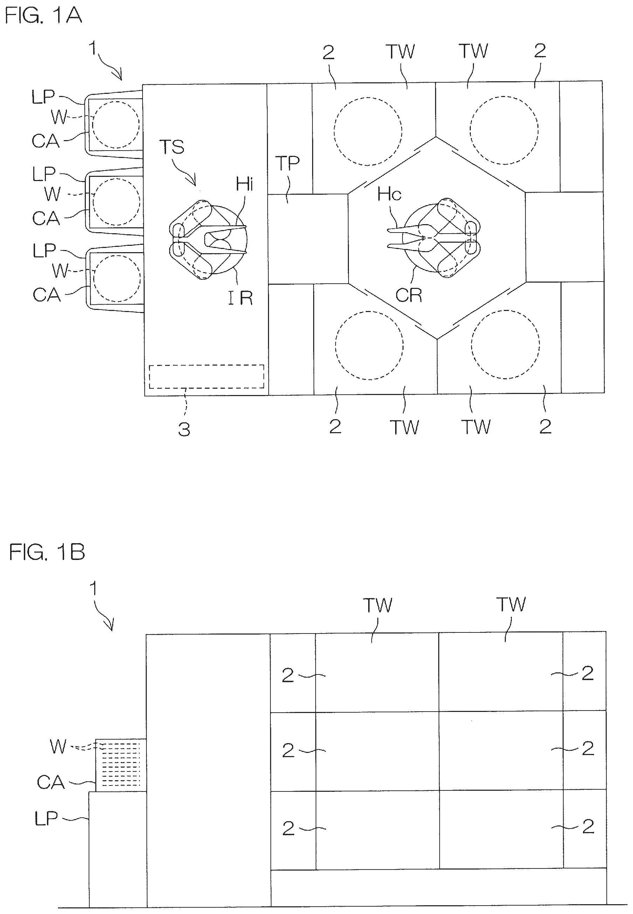

FIG. 1A is a schematic plan view showing a layout of the substrate processing apparatus 1 according to an embodiment of the present invention. FIG. 1B is a schematic side view of the substrate processing apparatus 1.

The substrate processing apparatus 1 is a single substrate processing type apparatus that processes disk-shaped substrates W such as semiconductor wafers one by one. The substrate processing apparatus 1 includes a load port LP that holds a carrier CA housing the substrate W, a plurality of processing units 2 that process the substrates W transferred from the carrier CA on the load port LP with a processing fluid such as a processing liquid or a processing gas, a transfer system TS that transfers the substrate W between the carrier CA on the load port LP and the plurality of processing units 2, and a controller 3 that controls the substrate processing apparatus 1.

The plurality of processing units 2 form a plurality of towers TW. FIG. 1A shows an example where four towers TW are formed. As shown in FIG. 1B, a plurality of processing units 2 included in a single tower TW are stacked vertically. As shown in FIG. 1A, the plurality of towers TW form two rows extending in the depth direction of the substrate processing apparatus 1 in a plan view. The two rows face each other across a transfer path TP in a plan view.

The transfer system TS includes an indexer robot IR that transfers the substrate W between the carrier CA on the load port LP and the plurality of processing units 2 and a center robot CR that transfers the substrate W between the indexer robot IR and the plurality of processing units 2. The indexer robot IR is disposed between the load port LP and the center robot CR in a plan view. The center robot CR is disposed in the transfer path TP.

The indexer robot IR includes one or more hands Hi that support the substrates W horizontally. The hand Hi is movable in parallel in both the horizontal direction and the vertical direction. The hand Hi is rotatable around a vertical line. The hand Hi can carry in and carry out the substrate W to and from the carrier CA on any of the load ports LP, and can receive and transfer the substrate W from and to the center robot CR.

The center robot CR includes one or more hands Hc that support the substrates W horizontally. The hand Hc is movable in parallel in both the horizontal direction and the vertical direction. The hand Hc is rotatable around a vertical line. The hand Hc can receive and transfer the substrate W from and to the indexer robot IR, and carry in and carry out the substrate W to and from any of the processing units 2.

Next, the processing unit 2 will be described.

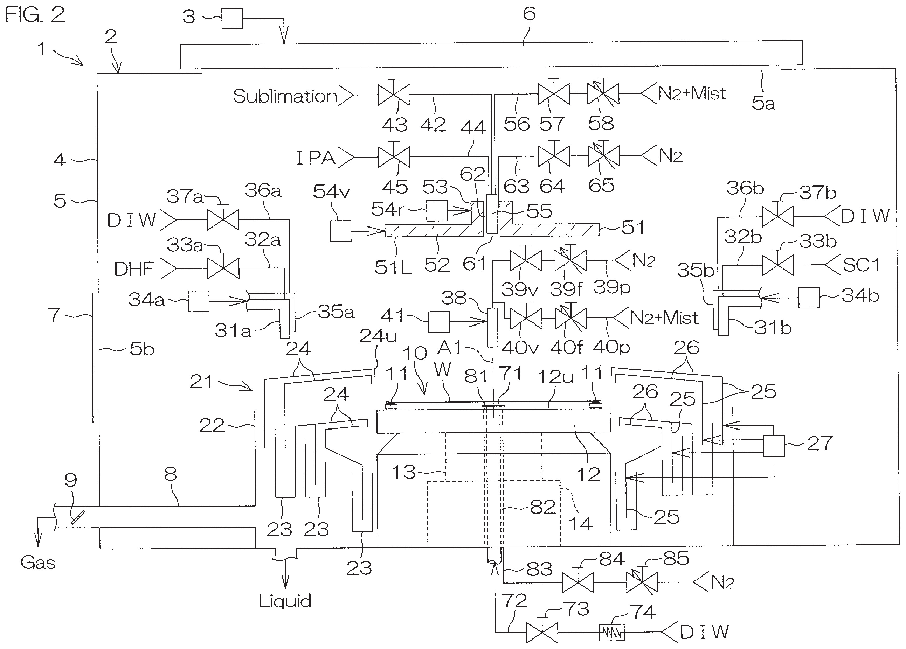

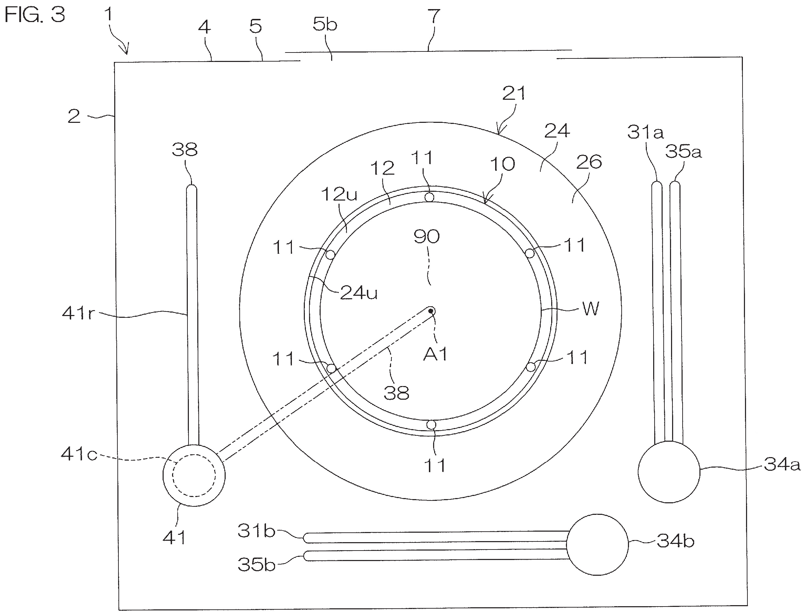

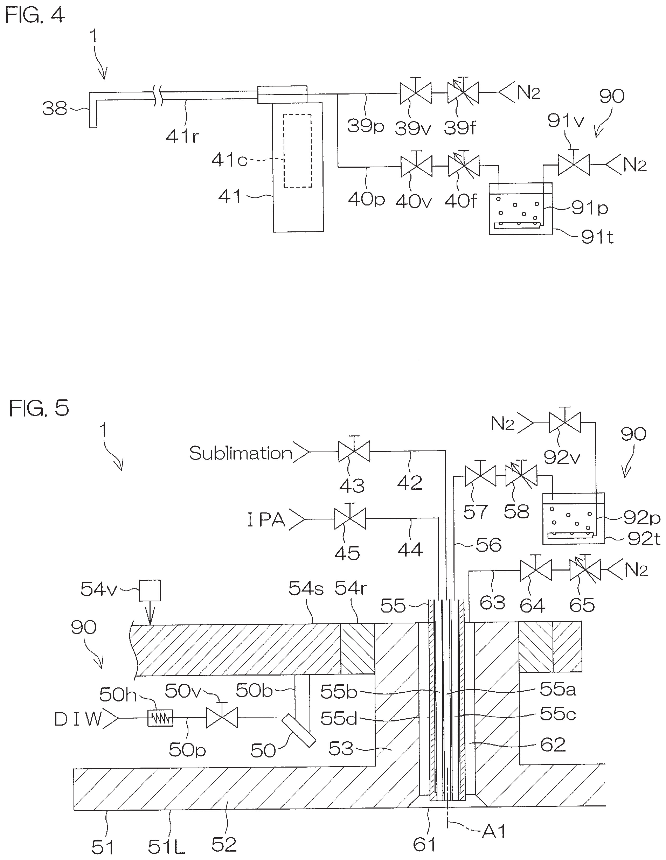

FIG. 2 is a schematic view of an interior of the processing unit 2 provided in the substrate processing apparatus 1 when viewed horizontally. FIG. 3 is a schematic view of the interior of the processing unit 2 when viewed from above. FIG. 4 is a schematic view of a gas nozzle 38 when viewed horizontally. FIG. 5 is a schematic cross-sectional view showing a vertical cross-section of a shielding member 51. "Sublimation" in FIG. 2 and FIG. 5 represents a sublimable substance-containing liquid

As shown in FIG. 2, the processing unit 2 includes a box-shaped chamber 4 having an interior space, a spin chuck 10 that rotates one substrate W around a vertical rotational axis A1 passing through the central portion of the substrate W while holding the substrate W horizontally in the chamber 4, and a tubular processing cup 21 surrounding the spin chuck 10 around the rotational axis A1.

The chamber 4 includes a box-shaped partition 5 provided with a carry-in/carry-out port 5b through which the substrate W passes, and a shutter 7 that opens and closes the carry-in/carry-out port 5b. An FFU 6 (Fan Filter Unit 7) is disposed over an air outlet 5a provided on the upper portion of the partition 5. The FFU 6 constantly supplies clean air (air that has been filtered by a filter) from the air outlet 5a to the chamber 4. The gas in the chamber 4 is discharged from the chamber 4 through a discharged gas duct 8 connected to the bottom portion of the processing cup 21. Thereby, a downflow of clean air is constantly formed inside the chamber 4. The flow rate of discharged gas discharged into the discharged gas duct 8 is changed according to the opening degree of a discharged gas valve 9 disposed in the discharged gas duct 8.

The spin chuck 10 includes a disk-shaped spin base 12 horizontally held, a plurality of chuck pins 11 that hold the substrate W horizontally above the spin base 12, a spin shaft 13 extending downward from the central portion of the spin base 12, and a spin motor 14 that rotates the spin base 12 and the plurality of chuck pins 11 by rotating the spin shaft 13.

The spin chuck 10 is not limited to a grippingtype chuck that contacts the plurality of chuck pins 11 with the end surface of substrate W, and may be a vacuum-type chuck that holds the substrate W horizontally by adsorbing the rear surface (lower surface) of the substrate W, which is a non-device forming surface, onto the upper surface 12u of the spin base 12. When the spin chuck 10 is the grippingtype chuck, the plurality of chuck pins 11 correspond to a substrate holder. When the spin chuck 10 is the vacuum-type chuck, the spin base 12 corresponds to the substrate holder.

The processing cup 21 includes a plurality of guards 24 that receive processing liquid discharged outward from the substrate W, a plurality of cups 23 that receive the processing liquid guided downward by the plurality of guards 24, and a cylindrical outer wall member 22 surrounding the plurality of guards 24 and the plurality of cups 23. FIG. 2 shows an example where four guards 24 and three cups 23 are provided and the outermost cup 23 is integral to the third guard 24 from the top.

The guard 24 includes a cylindrical portion 25 surrounding the spin chuck 10 and an annular ceiling portion 26 extending upward obliquely from the upper end portion of the cylindrical portion 25 toward the rotational axis A1. The plurality of ceiling portions 26 overlap each other vertically, and the plurality of cylindrical portions 25 are concentrically disposed. The annular upper end of the ceiling portion 26 corresponds to the upper end 24u of the guard 24 surrounding the substrate W and the spin base 12 in a plan view. The plurality of cup 23 are disposed under the plurality of cylindrical portions 25, respectively. The cup 23 forms an annular groove that receives the processing liquid guided downward by the guard 24.

The processing unit 2 includes a guard raising/lowering unit 27 that individually raises and lowers the plurality of guards 24. The guard raising/lowering unit 27 positions the guard 24 at any position within a range from an upper position to a lower position.FIG. 2 shows a state where two guards 24 are disposed at the upper position and the remaining two guards 24 are disposed at the lower position. The upper position is a position where the upper end 24u of the guard 24 is disposed above a holding position where the substrate W held by the spin chuck 10 is positioned. The lower position is a position where the upper end 24u of the guard 24 is disposed below the holding position.

The processing unit 2 includes a plurality of nozzles that discharge processing fluids toward the substrate W held by the spin chuck 10. The plurality of nozzles include a first chemical liquid nozzle 31a and a second chemical liquid nozzle 31b that discharge chemical liquids toward the upper surface of the substrate W and a first rinse liquid nozzle 35a and a second rinse liquid nozzle 35b that discharge a rinse liquid toward the upper surface of the substrate W. The gas nozzle 38, a central nozzle 55, and a lower surface nozzle 71 to be described later are also included in the plurality of nozzles.

The first chemical liquid nozzle 31a may be a scan nozzle that moves a collision position of the chemical liquid with respect to the substrate W within the upper surface of the substrate W or may be a fixed nozzle that cannot move the collision position of the chemical liquid with respect to the substrate W. The same applies to other nozzles. FIG. 2 shows an example where the first chemical liquid nozzle 31a, the second chemical liquid nozzle 31b, the first rinse liquid nozzle 35a, the second rinse liquid nozzle 35b, and the gas nozzle 38 are scan nozzles, and other nozzles are fixed nozzles.

The first chemical liquid nozzle 31a is connected to a first chemical liquid piping 32a that guides a chemical liquid. The second chemical liquid nozzle 31b is connected to a second chemical liquid piping 32b that guides a chemical liquid. When a first chemical liquid valve 33a attached to the first chemical liquid piping 32a is opened, the chemical liquid is continuously discharged downward from a discharge port of the first chemical liquid nozzle 31a. Similarly, when a second chemical liquid valve 33b attached to the second chemical liquid piping 32b is opened, the chemical liquid is continuously discharged downward from a discharge port of the second chemical liquid nozzle 31b.

FIG. 2 shows an example in which the first chemical liquid nozzle 31a discharges DHF and the second chemical liquid nozzle 31b discharges SC1. DHF (dilute hydrogen fluoride) represents dilute hydrofluoric acid. SC1 represents a liquid containing ammonium hydroxide, hydrogen peroxide, and water. The chemical liquid discharged from the first chemical liquid nozzle 31a may be a liquid that includes at least one of sulfuric acid, nitric acid, hydrochloric acid, hydrofluoric acid, phosphoric acid, acetic acid, ammonia water, hydrogen peroxide water, organic acids (for example, citric acid, oxalic acid, etc.), organic alkalis (for example, TMAH: tetramethylammonium hydroxide, etc.), surfactants, and corrosion inhibitors, or may be a liquid other than this. The same applies to the chemical liquid discharged from the second chemical liquid nozzle 31b. The chemical liquid discharged from the second chemical liquid nozzle 31b is a liquid that is different from the chemical liquid discharged from the first chemical liquid nozzle 31a in at least one of composition and temperature.

Although not shown, the first chemical liquid valve 33a includes a valve body provided with an annular valve seat through which a processing liquid passes, a valve element that can move with respect to the valve seat, and an actuator that moves the valve element between a closed position where the valve element contacts the valve seat and an open position where the valve element is away from the valve seat. The same applies to other valves. The actuator may be a pneumatic actuator or an electric actuator, or may be an actuator other than these. The controller 3 opens and closes the first chemical liquid valve 33a and the like by controlling the actuators.

The first rinse liquid nozzle 35a is connected to a first rinse liquid piping 36a that guides a rinse liquid. The second rinse liquid nozzle 35b is connected to a second rinse liquid piping 36b that guides a rinse liquid. When a first rinse liquid valve 37a attached to the first rinse liquid piping 36a is opened, the rinse liquid is continuously discharged downward from a discharge port of the first rinse liquid nozzle 35a. Similarly, when a second rinse liquid valve 37b attached to the second rinse liquid piping 36b is opened, the rinse liquid is continuously discharged downward from a discharge port of the second rinse liquid nozzle 35b.

FIG. 2 shows an example in which the first rinse liquid nozzle 35a and the second rinse liquid nozzle 35b discharge DIW. DIW (deionized water) represents pure water (deionized water). The rinse liquid discharged from the first rinse liquid nozzle 35a may be any one of carbonated water, electrolyzed ion water, hydrogen water, ozone water, and an aqueous hydrochloric acid solution of dilute concentration (for example, approximately 10 to 100 ppm) or may be a liquid other than these. The same applies to the rinse liquid discharged from the second rinse liquid nozzle 35b. The rinse liquid discharged from the second rinse liquid nozzle 35b may have the same composition and temperature as the rinse liquid discharged from the first rinse liquid nozzle 35a, or may have different composition and temperature.

The first chemical liquid nozzle 31a and the first rinse liquid nozzle 35a are connected to a first nozzle moving unit 34a that moves the first chemical liquid nozzle 31a and the first rinse liquid nozzle 35a in at least one of the vertical direction and the horizontal direction. The first nozzle moving unit 34a horizontally moves the first chemical liquid nozzle 31a and the first rinse liquid nozzle 35a between a processing position where the processing liquid discharged from the first chemical liquid nozzle 31a or the first rinse liquid nozzle 35a is supplied to the upper surface of the substrate W and a standby position where the first chemical liquid nozzle 31a and the first rinse liquid nozzle 35a are positioned around the processing cup 21 in a plan view.

Similarly, the second chemical liquid nozzle 31b and the second rinse liquid nozzle 35b are connected to a second nozzle moving unit 34b that moves the second chemical liquid nozzle 31b and the second rinse liquid nozzle 35b in at least one of the vertical direction and the horizontal direction. The second nozzle moving unit 34b horizontally moves the second chemical liquid nozzle 31b and the second rinse liquid nozzle 35b between a processing position where the processing liquid discharged from the second chemical liquid nozzle 31b or the second rinse liquid nozzle 35b is supplied to the upper surface of the substrate W and a standby position where the second chemical liquid nozzle 31b and the second rinse liquid nozzle 35b are positioned around the processing cup 21 in a plan view.

The plurality of nozzles include a lower surface nozzle 71 that discharges a processing liquid toward a lower surface central portion of the substrate W. The lower surface nozzle 71 includes a disk portion disposed between the upper surface 12u of the spin base 12 and the lower surface of the substrate W, and a tubular portion extending downward from the disk portion. A discharge port of the lower surface nozzle 71 opens at an upper surface central portion of the disk portion. When the substrate W is held by the spin chuck 10, the discharge port of the lower surface nozzle 71 faces the lower surface central portion of the substrate W vertically.

The lower surface nozzle 71 is connected to a rinse liquid piping 72 that guides a rinse liquid. FIG. 2 shows an example in which the rinse liquid is pure water. When a rinse liquid valve 73 attached to the rinse liquid piping 72 is opened, the rinse liquid is continuously discharged upward from the discharge port of the lower surface nozzle 71. The temperature of the rinse liquid at the time of being discharged from the lower surface nozzle 71 may be equal to or different from room temperature (for example, 20°C to 30°C). In the latter case, the rinse liquid before being supplied to the lower surface nozzle 71 may be heated by a heater 74. In the example shown in FIG. 2, warm water (pure water having a temperature higher than room temperature) as an example of the heating fluid is discharged from the lower surface nozzle 71 toward the lower surface of the substrate W.

An outer circumferential surface of the lower surface nozzle 71 and an inner circumferential surface of the spin base 12 form a tubular gas flow passage 82 that extends vertically. The gas flow passage 82 includes a central opening 81 opening at a central portion of the upper surface 12u of the spin base 12. The gas flow passage 82 is connected to an inert gas piping 83 that guides an inert gas. When an inert gas valve 84 attached to the inert gas piping 83 is opened, the inert gas is continuously discharged upward from the central opening 81 of the spin base 12 at a flow rate corresponding to the opening degree of a flow control valve 85 that changes the flow rate of the inert gas.

The inert gas discharged from the central opening 81 of the spin base 12 is nitrogen gas. The inert gas may instead be a gas other than nitrogen gas, such as helium gas or argon gas, etc. When the substrate W is held by the spin chuck 10 and the central opening 81 of the spin base 12 discharges the nitrogen gas, the nitrogen gas flows radially in all directions between the lower surface of the substrate W and the upper surface 12u of the spin base 12. A space between the substrate W and the spin base 12 is thereby filled with the nitrogen gas.

The plurality of nozzles include a gas nozzle 38 that discharges gas toward the upper surface of the substrate W. The gas nozzle 38 is also an example of a humidifying gas nozzle. The gas nozzle 38 is connected to an inert gas piping 39p that guides an inert gas such as nitrogen gas and a humidifying gas piping 40p that guides a humidifying gas that increases the humidity in an atmosphere in contact with the substrate W. The humidifying gas is, for example, nitrogen gas containing atomized water. "Mist" in FIG. 2 represents atomized liquid. The same applies to other drawings. The gas contained in the humidifying gas may be an inert gas other than the nitrogen gas or may be a gas other than the inert gas.

The humidifying gas is a moist gas having humidity higher than that of an atmosphere in contact with the substrate W. The substrate W is in contact with the clean air supplied from the FFU 6. Therefore, the humidity of the humidifying gas is higher than the humidity of the clean air. The temperature of the humidifying gas may be equal to or different from room temperature. The humidity of the humidifying gas is higher than the humidity of the inert gas guided by the inert gas piping 39p. The inert gas guided by the inert gas piping 39p is a dry gas having humidity lower than that of the humidifying gas. The inert gas guided by a piping other than the inert gas piping 39p is also a dry gas. The humidifying gas is a wet gas having humidity higher than that of the dry gas.

The inside of the chamber 4 is filled with the clean air supplied from the FFU 6. The substrate W is in contact with the atmosphere in the chamber 4. The humidity in the chamber 4 corresponds to the humidity of the atmosphere in contact with the substrate W. When the gas nozzle 38 discharges the humidifying gas, the humidity in the chamber 4 increases to a value at which no dew condensation occurs on the substrate W. This value fluctuates depending on environmental conditions including the temperature and atmospheric pressure in the chamber 4 and the temperature and speed of the gas flowing along the substrate W. Therefore, the humidity in the chamber 4 may be increased according to the environmental conditions. For example, the humidity in the chamber 4 may be increased by about 10%.

As shown in FIG. 4, the substrate processing apparatus 1 includes a humidifying gas generator that generates a humidifying gas. The humidifying gas generator includes a first liquid tank 91t that stores a liquid and a first dry gas piping 91p that atomizes the liquid in the first liquid tank 91t by supplying a dry gas having humidity lower than that of the humidifying gas into the first liquid tank 91t. The liquid in the first liquid tank 91t is pure water. The dry gas is nitrogen gas. The liquid in the first liquid tank 91t may be a liquid other than pure water. The dry gas may be a gas other than nitrogen gas.

The first dry gas piping 91p is a bubbling piping including a discharge port disposed in the liquid in the first liquid tank 91t. When a dry gas valve 91v attached to the first dry gas piping 91p is opened, the dry gas is discharged from the discharge port of the first dry gas piping 91p, and a large number of bubbles are formed in the liquid in the first liquid tank 91t. A large number of bubbles are discharged from the surface of the liquid in the first liquid tank 91t to the space in the first liquid tank 91t. At this time, mist of the liquid is generated in the space in the first liquid tank 91t. As a result, a dry gas containing atomized liquid, that is, a humidifying gas is generated in the first liquid tank 91t. The humidifying gas in the first liquid tank 91t is supplied to the gas nozzle 38 via the humidifying gas piping 40p.

When an inert gas valve 39v attached to the inert gas piping 39p is opened, the nitrogen gas is continuously discharged downward from a discharge port of the gas nozzle 38 at a flow rate corresponding to the opening degree of a flow control valve 39f that changes the flow rate of the inert gas. Similarly, when a humidifying gas valve 40v attached to the humidifying gas piping 40p is opened, the humidifying gas is continuously discharged downward from the discharge port of the gas nozzle 38 at a flow rate corresponding to the opening degree of a flow control valve 40f that changes the flow rate of the humidifying gas. When both the inert gas valve 39v and the humidifying gas valve 40v are opened, a mixed gas of the nitrogen gas and the humidifying gas is continuously discharged downward from the discharge port of the gas nozzle 38.

The mixed gas of the nitrogen gas and the humidifying gas is a gas having humidity higher than that of the atmosphere in contact with the substrate W. The humidity of the mixed gas is higher than the humidity of the nitrogen gas supplied by the inert gas piping 39p and lower than the humidity of the humidifying gas guided by the humidifying gas piping 40p. The humidity of the gas discharged from the gas nozzle 38 is continuously changed within a range from a value equal to the humidity of the nitrogen gas supplied by the inert gas piping 39p to a value equal to the humidity of the humidifying gas guided by the humidifying gas piping 40p by changing the opening degree of at least one of the flow control valve 39f and the flow control valve 40f.

The gas nozzle 38 is connected to a nozzle moving unit 41 that moves the gas nozzle 38 in at least one of the vertical direction and the horizontal direction. The nozzle moving unit 41 horizontally moves the gas nozzle 38 between a processing position (a position indicated by an alternate long and two short dashed line in FIG. 3) at which the gas discharged from the gas nozzle 38 is supplied to the upper surface of the substrate W and a standby position (a position indicated by a solid line in FIG. 3) at which the gas nozzle 38 is positioned around the processing cup 21 in a plan view.

The nozzle moving unit 41 horizontally moves the gas nozzle 38 along an arc-shaped path passing through the center of the substrate W in a plan view by rotating the gas nozzle 38 around a vertical straight line positioned outside the processing cup 21. Since the radius of the arc-shaped path is large, the gas nozzle 38 horizontally moves along a path that can be regarded as a straight line in a plan view. The nozzle moving unit 41 may horizontally move the gas nozzle 38 in parallel instead of rotating the gas nozzle 38.

The nozzle moving unit 41 includes an actuator 41c that generates power to move the gas nozzle 38 between the processing position and the standby position and a nozzle arm 41r that transmits the power of the actuator 41c to the gas nozzle 38. The nozzle arm 41r is an example of a transmission element that transmits the power of the actuator 41c to the gas nozzle 38. The gas nozzle 38 extends downward from the tip of the nozzle arm 41r. The gas nozzle 38 may be integrated with the nozzle arm 41r or may be a member that is separate from the nozzle arm 41r and is fixed to the nozzle arm 41r.

The actuator 41c is a device that converts driving energy, which represents electrical, fluid, magnetic, thermal or chemical energy, to mechanical work. The actuator 41c includes an electric motor (rotary motor), linear motor, air cylinder and other devices. In a case where the actuator 41c is an electric motor and the gas nozzle 38 is to be moved horizontally in parallel, the rotation of the actuator 41 may be converted into a linear motion of the gas nozzle 38 by a motion converter such as a ball screw and ball nut. The content of this paragraph also applies to other actuators.

As shown in FIG. 2, the processing unit 2 includes a shielding member 51 disposed above the spin chuck 10. FIG. 2 shows an example in which the shielding member 51 is a disk-shaped shielding plate. The shielding member 51 includes a disk portion 52 disposed horizontally above the spin chuck 10. The shielding member 51 is supported horizontally by a tubular support shaft 53 extending upward from a central portion of the disk portion 52. A center line of the disk portion 52 is disposed on the rotational axis A1 of the substrate W. A lower surface of the disk portion 52 corresponds to a lower surface 51L of the shielding member 51. The lower surface 51L of the shielding member 51 is parallel to the upper surface of the substrate W and has an outer diameter not less than a diameter of the substrate W.

The shielding member 51 is connected to a vertical actuator 54v that vertically moves the shielding member 51 in parallel. The vertical actuator 54v positions the shielding member 51 at any position within a range from an upper position (a position shown in FIG. 2) to a lower position. The lower position is a proximity position at which the lower surface 51L of the shielding member 51 approaches the upper surface of the substrate W to a height such that a scan nozzle, such as the first chemical liquid nozzle 31a, cannot enter between the substrate W and the shielding member 51. The upper position is a standby position at which the shielding member 51 is retreated to a height that allows a scan nozzle to enter between the shielding member 51 and the substrate W. An intermediate position to be described later is a position between the upper position and the lower position where a scan nozzle cannot enter between the substrate W and the shielding member 51.

The shielding member 51 is further connected to a rotary actuator 54r that rotates the shielding member 51 about the vertical rotational axis A1 passing through a central portion of the shielding member 51. The rotational axis A1 of the shielding member 51 is the same axis as the rotational axis A1 of the substrate W. As shown in FIG. 5, the shielding member 51 is supported by a support arm 54s via the rotary actuator 54r. The rotary actuator 54r rotates the shielding member 51 with respect to the support arm 54s. The vertical actuator 54v raises and lowers the shielding member 51 by raising and lowering the support arm 54s. The support arm 54s is disposed above the disk portion 52 of the shielding member 51.

The substrate processing apparatus 1 includes a cleaning liquid nozzle 50 that discharges a cleaning liquid toward the shielding member 51. FIG. 5 shows an example in which the cleaning liquid is pure water. The cleaning liquid may be a liquid other than pure water. A specific example of the cleaning liquid is similar to a specific example of the rinse liquid. The cleaning liquid nozzle 50 is disposed above the shielding member 51. The cleaning liquid nozzle 50 is supported by the support arm 54s via a support bracket 50b. The cleaning liquid nozzle 50 moves up and down together with the shielding member 51. Even if the shielding member 51 rotates, the cleaning liquid nozzle 50 does not rotate.

The cleaning liquid nozzle 50 is connected to a cleaning liquid piping 50p that guides a cleaning liquid. When a cleaning liquid valve 50v attached to the cleaning liquid piping 50p is opened, the cleaning liquid is continuously discharged downward from a discharge port of the cleaning liquid nozzle 50. The temperature of the cleaning liquid at the time of being discharged from the cleaning liquid nozzle 50 may be equal to or different from room temperature. In the latter case, the cleaning liquid before being supplied to the cleaning liquid nozzle 50 may be heated by a heater 50h. The cleaning liquid nozzle 50 discharges the cleaning liquid toward an upper surface of the disk portion 52 corresponding to an upper surface of the shielding member 51. FIG. 5 shows an example in which a direction in which the cleaning liquid nozzle 50 discharges the cleaning liquid is inclined toward the rotational axis A1 of the shielding member 51 with respect to the vertical direction.

The plurality of nozzles include a central nozzle 55 that discharges a processing fluid, such as a processing liquid or a processing gas, downward via a central opening 61 opening at a central portion of the lower surface 51L of the shielding member 51. The central nozzle 55 extends vertically along the rotational axis A1. An inner circumferential surface of the shielding member 51 surrounds an outer circumferential surface of the central nozzle 55 at an interval. The inner circumferential surface of the shielding member 51 forms a flow passage extending upward from the central opening 61. The central nozzle 55 moves up and down together with the shielding member 51. A discharge port of the central nozzle 55 that discharges a processing fluid is disposed above the central opening 61 of the shielding member 51. The central nozzle 55 and the central opening 61 are examples of gas nozzles. The central nozzle 55 is also an example of a humidifying gas nozzle.

The central nozzle 55 includes a plurality of inner tubes that discharge the processing fluid downward and a tubular casing 55d surrounding the plurality of inner tubes. FIG. 5 shows an example in which three inner tubes, that is, a first tube 55a, a second tube 55b, and a third tube 55c are provided. The inner circumferential surface of the shielding member 51 surrounds an outer circumferential surface of the casing 55d at an interval. The outer circumferential surface of the casing 55d corresponds to the outer circumferential surface of the central nozzle 55. A discharge port of the first tube 55a, a discharge port of the second tube 55b, and a discharge port of the third tube 55c correspond to the discharge ports of the central nozzle 55.

The first tube 55a is connected to a sublimable substance-containing liquid piping 42 that guides a sublimable substance-containing liquid. The second tube 55b is connected to a replacement liquid piping 44 that guides a replacement liquid. The third tube 55c is connected to a humidifying gas piping 56 that guides a humidifying gas. The first tube 55a is an example of a sublimable substance-containing liquid nozzle. The second tube 55b is an example of a replacement liquid nozzle. The third tube 55c is an example of a gas nozzle and a humidifying nozzle. FIG. 5 shows an example in which the replacement liquid is IPA (isopropyl alcohol).

As described above, the substrate processing apparatus 1 includes a humidifying gas generator that generates a humidifying gas. The humidifying gas generator includes a second liquid tank 92t that stores a liquid, and a second dry gas piping 92p that atomizes the liquid in the second liquid tank 92t by supplying a dry gas having humidity lower than that of the humidifying gas into the second liquid tank 92t. The liquid in the second liquid tank 92t is pure water. The dry gas is nitrogen gas. The liquid in the second liquid tank 92t may be a liquid other than pure water. The dry gas may be a gas other than nitrogen gas.

The second dry gas piping 92p is a bubbling piping including a discharge port disposed in the liquid in the second liquid tank 92t. When a dry gas valve 92v attached to the second dry gas piping 92p is opened, the dry gas is discharged from the discharge port of the second dry gas piping 92p, and a large number of bubbles are formed in the liquid in the second liquid tank 92t. A large number of bubbles are discharged from the surface of the liquid in the second liquid tank 92t to the space in the second liquid tank 92t. At this time, mist of the liquid is generated in the space in the second liquid tank 92t. As a result, a dry gas containing atomized liquid, that is, a humidifying gas is generated in the second liquid tank 92t. The humidifying gas in the second liquid tank 92t is supplied to the third tube 55c via the humidifying gas piping 56.

When a sublimable substance-containing liquid valve 43 attached to the sublimable substance-containing liquid piping 42 is opened, the sublimable substance-containing liquid is continuously discharged downward from the discharge port of the first tube 55a. Similarly, when a replacement liquid valve 45 attached to the replacement liquid piping 44 is opened, the replacement liquid is continuously discharged downward from the discharge port of the second tube 55b. When a humidifying gas valve 57 attached to the humidifying gas piping 56 is opened, the humidifying gas is continuously discharged downward from the discharge port of the third tube 55c at a flow rate corresponding to the opening degree of a flow control valve 58 that changes the flow rate of the humidifying gas.

The sublimable substance-containing liquid is a solution containing a sublimable substance corresponding to a solute and a solvent that blends together with the sublimable substance. The sublimable substance-containing liquid may be a melt of a sublimable substance (liquid sublimable substance). The sublimable substance-containing liquid may further contain a substance other than the sublimable substance and the solvent. The sublimable substance may be a substance that changes from a solid to a gas without transition to a liquid at a normal temperature (synonymous with room temperature) or a normal pressure (the pressure in the substrate processing apparatus 1, for example, one atmospheric pressure or a value in its vicinity).

The freezing point of a sublimable substance-containing liquid (the freezing point at one atmospheric pressure; the same applies hereinafter) is lower than room temperature (for example, 20°C to 30°C). The substrate processing apparatus 1 is disposed inside the clean room maintained at room temperature. Therefore, the sublimable substance-containing liquid can be maintained as a liquid without heating the sublimable substance-containing liquid. The freezing point of the sublimable substance is higher than the freezing point of the sublimable substance-containing liquid. The freezing point of the sublimable substance is higher than room temperature. At room temperature, the sublimable substance is a solid. The freezing point of the sublimable substance may be higher than the boiling point of the solvent. The vapor pressure of the solvent is higher than the vapor pressure of the sublimable substance.

The sublimable substance may be, for example, any of alcohols, such as 2-methyl-2-propanol (synonyms: tert-butyl alcohol, t-butyl alcohol or tertiary butyl alcohol), cyclohexanol, etc., fluorohydrocarbons, 1,3,5-trioxane (synonym: metaformaldehyde), camphor (synonyms: camphre, campher), naphthalene, and iodine or may be a substance other than these. The sublimable substance may be cyclohexanone oxime, pinacolin oxime, or acetophenone oxime.

The solvent may be, for example, at least one type selected from the group consisting of pure water, IPA, methanol, HFE (hydrofluoroether), acetone, PGMEA (propylene glycol monomethyl ether acetate), PGEE (propylene glycol monoethyl ether, 1-ethoxy-2-propanol), and ethylene glycol. IPA has a higher vapor pressure than water and a lower surface tension than water.

As shall be described below, the replacement liquid is supplied to the upper surface of the substrate W that is covered by a liquid film of the rinse liquid and the sublimable substance-containing liquid is supplied to the upper surface of the substrate W that is covered by a liquid film of the replacement liquid. The replacement liquid may be any liquid as long as it blends together with both the rinse liquid and the sublimable substance-containing liquid. The replacement liquid is, for example, IPA (liquid). The replacement liquid may be a mixed liquid of IPA and HFE or may be other than these.

As shown in FIG. 5, the inner circumferential surface of the shielding member 51 and the outer circumferential surface of the central nozzle 55 form a tubular gas flow passage 62 that extends vertically. The gas flow passage 62 is connected to an inert gas piping 63 that guides an inert gas. When an inert gas valve 64 attached to the inert gas piping 63 is opened, the inert gas is continuously discharged downward from the central opening 61 of the shielding member 51 at a flow rate corresponding to the opening degree of a flow control valve 65 that changes the flow rate of the inert gas. The inert gas discharged from the central opening 61 of the shielding member 51 is nitrogen gas. The inert gas may instead be a gas other than nitrogen gas, such as helium gas or argon gas, etc.

The substrate processing apparatus 1 includes a humidifier 90 that increases the humidity of the atmosphere in contact with the substrate W. The gas nozzle 38 shown in FIG. 4, etc., is included in the humidifier 90. Each element disposed in the path from the first dry gas piping 91p to the gas nozzle 38, such as the first liquid tank 91t, is also included in the humidifier 90. Similarly, the central nozzle 55 shown in FIG. 5, etc., is included in the humidifier 90. Each element disposed in the path from the second dry gas piping 92p to the central nozzle 55, such as the second liquid tank 92t, is also included in the humidifier 90.

The cleaning liquid nozzle 50 and the lower surface nozzle 71 are included in the humidifier 90. The cleaning liquid nozzle 50 and the lower surface nozzle 71 are examples of a liquid column nozzle that changes a liquid into a plurality of droplets by making the liquid collide with a rotating body such as the shielding member 51 and the substrate W. When the cleaning liquid nozzle 50 discharges a liquid, a liquid column extending from the discharge port of the cleaning liquid nozzle 50 to the shielding member 51 is formed. Similarly, when the lower surface nozzle 71 discharges a liquid, a liquid column extending from the discharge port of the lower surface nozzle 71 to the substrate W is formed. Each element disposed in the path from the cleaning liquid piping 50p to the cleaning liquid nozzle 50 is also included in the humidifier 90. Similarly, each element disposed in the path from the rinse liquid piping 72 to the lower surface nozzle 71 is also included in the humidifier 90.

Next, an electrical arrangement of the substrate processing apparatus 1 will be described.

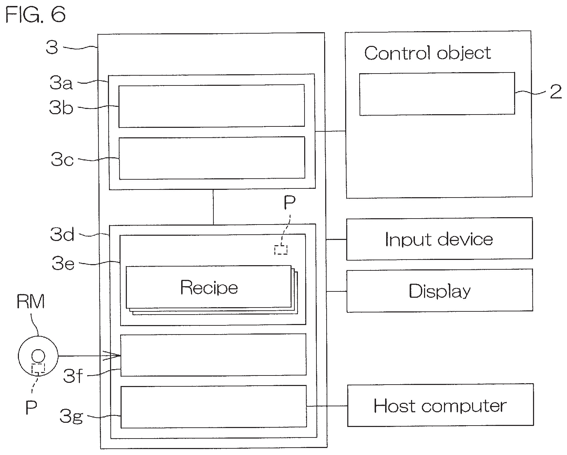

FIG. 6 is a block diagram showing an electrical arrangement of the substrate processing apparatus 1. The controller 3 includes at least one computer. The computer includes a computer main body 3a and a peripheral device 3d connected to the computer main body 3a. The computer main body 3a includes a CPU 3b (central processing unit) that executes various types of commands and a memory 3c that stores information. The peripheral device 3d includes a storage 3e that stores information to be sent to and received from the memory 3c such as a program P, a reader 3f that reads information from a removable medium RM, and a communication device 3g that communicates with other devices such as a host computer. The memory 3c and storage 3e are both examples of a memory that store information to be sent to and received from the CPU 3b.

The controller 3 is connected to an input device and a display. The input device is operated when an operator such as a user or a maintenance operator inputs information to the substrate processing apparatus 1. The information is displayed on the screen of the display. The input device may be any one of a keyboard, a pointing device and a touch panel or may be a device other than those. A touch panel display that serves both as the input device and the display may be provided in the substrate processing apparatus 1.

The CPU 3b executes the program P stored in the storage 3e. The program P within the storage 3e may be previously installed in the controller 3, may be fed through the reader 3f from the removable medium RM to the storage 3e or may be fed from an external device such as the host computer to the storage 3e through the communication device 3g.

The memory 3c is a volatile memory that retains memory only when power is supplied. The storage 3e and the removable medium RM are non-volatile memories that retain memory even when power is not supplied. The storage 3e is, for example, a magnetic storage device such as a hard disk drive. The removable medium RM is, for example, an optical disc such as a compact disc or a semiconductor memory such as a memory card. The removable medium RM is an example of a computer readable recording medium in which the program P is recorded. The removable medium RM is a non-transitory tangible recording medium (non-transitory tangible media).

The storage 3e stores a plurality of recipes. The recipe is information that defines the processing content, processing condition, and processing procedure for the substrate W. A plurality of recipes differ from each other in at least one of the processing content, processing condition, and processing procedure for the substrate W. The controller 3 controls the substrate processing apparatus 1 such that the substrate W is processed according to the recipe designated by the host computer. The controller 3 is programmed to execute the individual steps described below.

Next, an example of processing of the substrate W will be described.

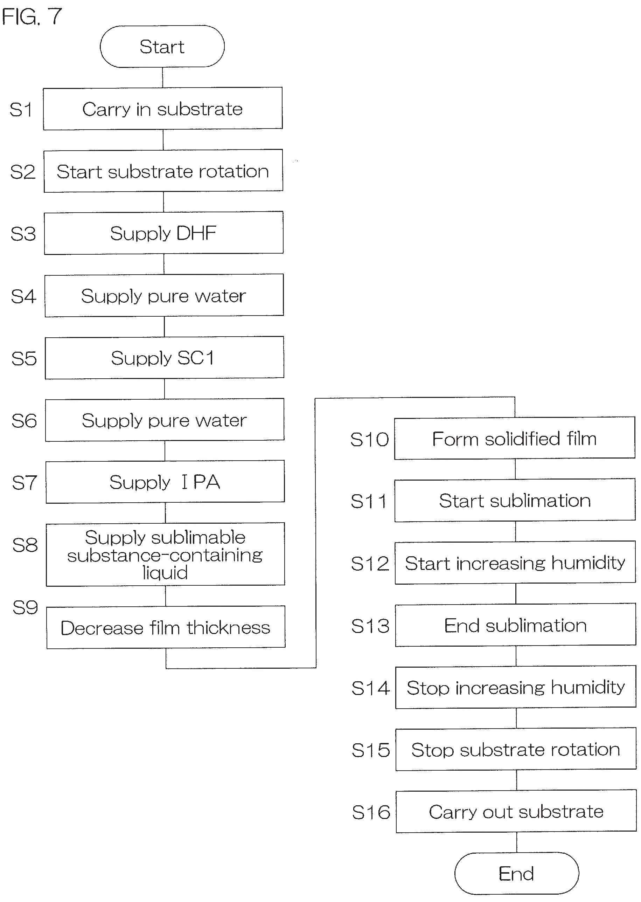

FIG. 7 is a process chart for describing an example of processing of a substrate performed by the substrate processing apparatus 1. In the following, FIG. 2 and FIG. 7 will be referenced.

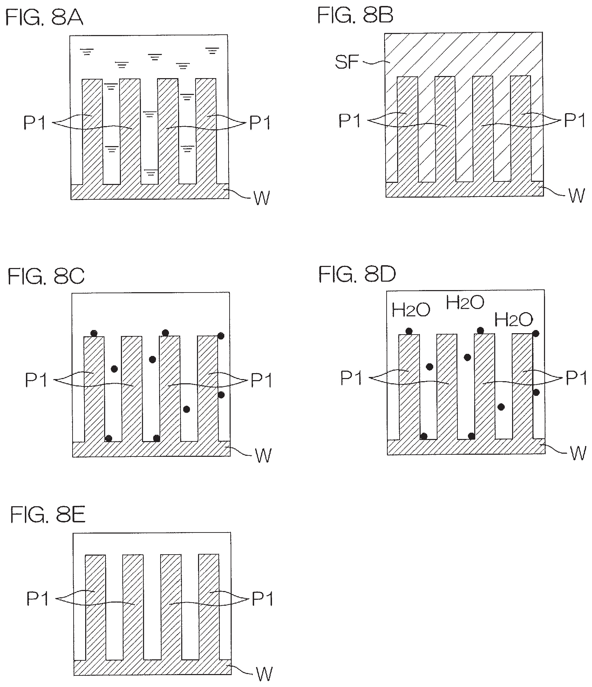

The substrate W to be processed is, for example, a semiconductor wafer, such as a silicon wafer. The substrate W may be a substrate W having patterns P1 (see FIG. 8A) formed on the front surface of the substrate W or may be a substrate W without the patterns P1 formed on the front surface of the substrate W. In the latter case, the patterns P1 may be formed in a first chemical liquid supplying step or a second chemical liquid supplying step to be described later. The front surface of the substrate W immediately before the sublimable substance-containing liquid is supplied may be either hydrophilic or hydrophobic. The front surface of the substrate W may be terminated with at least one of a hydroxyl group and a hydrogen atom or may be terminated with an atom or an atom group other than these.

When the substrate W is to be processed by the substrate processing apparatus 1, a carry-in step (step S1 in FIG. 7) of carrying the substrate W into the chamber 4 is performed.

Specifically, in a state where the shielding member 51 is positioned at the upper position, all of the guards 24 are positioned at the lower position, and all of the scan nozzles are positioned at the standby position, the center robot CR (see FIG. 1A) makes the hand Hc enter inside the chamber 4 while supporting the substrate W with the hand Hc. Thereafter, the center robot CR places the substrate W, on the hand Hc, on the plurality of chuck pins 11 in a state where the front surface of the substrate W is faced upward. Thereafter, the plurality of chuck pins 11 are pressed against the end surface of the substrate W and the substrate W is gripped. After placing the substrate W on the spin chuck 10, the center robot CR makes the hand Hc retreat from inside the chamber 4.

Next, the inert gas valve 84 is opened, and the central opening 81 of the spin base 12 starts discharging the nitrogen gas. A space between the substrate W and the spin base 12 is thereby filled with the nitrogen gas. Meanwhile, the guard raising/lowering unit 27 raises at least one of the guards 24 from the lower position to the upper position. Thereafter, the spin motor 14 is driven and rotation of the substrate W is started (step S2 in FIG. 7). Similarly, the rotary actuator 54r is driven and rotation of the shielding member 51 is started. The rotational speed and the rotation direction of the shielding member 51 are controlled to match the rotational speed and the rotation direction of the substrate W until the rotation of the substrate W is stopped.

Next, a first chemical liquid supplying step (step S3 in FIG. 7) of supplying DHF, which is an example of a chemical liquid, to the upper surface of the substrate W to form a liquid film of the DHF covering the entire upper surface of the substrate W is performed.

Specifically, in a state where the shielding member 51 is positioned at the upper position and at least one of the guards 24 is positioned at the upper position, the first nozzle moving unit 34a moves the first chemical liquid nozzle 31a and the first rinse liquid nozzle 35a from the standby position to the processing position. Thereafter, the first chemical liquid valve 33a is opened, and the first chemical liquid nozzle 31a starts discharging the DHF. When a predetermined time elapses from when the first chemical liquid valve 33a was opened, the first chemical liquid valve 33a is closed, and the discharge of the DHF is stopped.

The DHF discharged from the first chemical liquid nozzle 31a collides with the upper surface of the substrate W that is rotating at the first chemical liquid supplying speed and thereafter flows outward along the upper surface of the substrate W due to a centrifugal force. The DHF is thus supplied to the entire upper surface of the substrate W and the liquid film of the DHF that covers the entire upper surface of the substrate W is formed. While the first chemical liquid nozzle 31a is discharging the DHF, the first nozzle moving unit 34a may move a collision position of the DHF with respect to the upper surface of the substrate W such that the collision position passes through a central portion and an outer peripheral portion or may keep the collision position still at the central portion. The same applies to the processing liquid supplied to the upper surface of the substrate W after the DHF as to whether or not to move the collision position.

Next, a first rinse liquid supplying step (step S4 in FIG. 7) of supplying pure water, which is an example of the rinse liquid, to the upper surface of the substrate W to rinse off the DHF on the substrate W is performed.

Specifically, in a state where the shielding member 51 is positioned at the upper position, at least one of the guards 24 is positioned at the upper position, and the first chemical liquid nozzle 31a and the first rinse liquid nozzle 35a are positioned at the processing position, the first rinse liquid valve 37a is opened, and the first rinse liquid nozzle 35a starts discharging pure water. Before the discharge of the pure water is started, the guard raising/lowering unit 27 may move at least one of the guards 24 vertically to switch the guard 24 that receives the liquid expelled from the substrate W.

The pure water discharged from the first rinse liquid nozzle 35a collides with the upper surface of the substrate W that is rotating at the first rinse liquid supplying speed and thereafter flows outward along the upper surface of the substrate W due to a centrifugal force. The DHF on the substrate W is replaced by the pure water discharged from the first rinse liquid nozzle 35a. A liquid film of the pure water that covers the entire upper surface of the substrate W is thereby formed. When a predetermined time elapses from when the first rinse liquid valve 37a was opened, the first rinse liquid valve 37a is closed and the discharge of the pure water is stopped. Thereafter, the first nozzle moving unit 34a moves the first chemical liquid nozzle 31a and the first rinse liquid nozzle 35a to the standby position.

Next, a second chemical liquid supplying step (step S5 in FIG. 7) of supplying SC1, which is an example of a chemical liquid, to the upper surface of the substrate W to form a liquid film of the SC1 covering the entire upper surface of the substrate W is performed.

Specifically, in a state where the shielding member 51 is positioned at the upper position and at least one of the guards 24 is positioned at the upper position, the second nozzle moving unit 34b moves the second chemical liquid nozzle 31b and the second rinse liquid nozzle 35b from the standby position to the processing position. Thereafter, the second chemical liquid valve 33b is opened, and the second chemical liquid nozzle 31b starts discharging the SC1. Before the discharge of the SC1 is started, the guard raising/lowering unit 27 may move at least one of the guards 24 vertically to switch the guard 24 that receives the liquid expelled from the substrate W.

The SC1 discharged from the second chemical liquid nozzle 31b collides with the upper surface of the substrate W that is rotating at the second chemical liquid supplying speed and thereafter flows outward along the upper surface of the substrate W due to a centrifugal force. The pure water on the substrate W is replaced by the SC1 discharged from the second chemical liquid nozzle 31b. A liquid film of the SC1 that covers the entire upper surface of the substrate W is thereby formed. When a predetermined time elapses from when the second chemical liquid valve 33b was opened, the second chemical liquid valve 33b is closed and the discharge of the SC1 is stopped.

Next, a second rinse liquid supplying step (step S6 in FIG. 7) of supplying pure water, which is an example of the rinse liquid, to the upper surface of the substrate W to rinse off the SC1 on the substrate W is performed.

Specifically, in a state where the shielding member 51 is positioned at the upper position, at least one of the guards 24 is positioned at the upper position, and the second chemical liquid nozzle 31b and the second rinse liquid nozzle 35b are positioned at the processing position, the second rinse liquid valve 37b is opened, and the second rinse liquid nozzle 35b starts discharging pure water. Before the discharge of the pure water is started, the guard raising/lowering unit 27 may move at least one of the guards 24 vertically to switch the guard 24 that receives the liquid expelled from the substrate W.

The pure water discharged from the second rinse liquid nozzle 35b collides with the upper surface of the substrate W that is rotating at the second rinse liquid supplying speed and thereafter flows outward along the upper surface of the substrate W due to a centrifugal force. The SC1 on the substrate W is replaced by the pure water discharged from the second rinse liquid nozzle 35b. A liquid film of the pure water that covers the entire upper surface of the substrate W is thereby formed. When a predetermined time elapses from when the second rinse liquid valve 37b was opened, the second rinse liquid valve 37b is closed and the discharge of the pure water is stopped. Thereafter, the second nozzle moving unit 34b moves the second chemical liquid nozzle 31b and the second rinse liquid nozzle 35b to the standby position.

Next, a replacement liquid supplying step (step S7 in FIG. 7) of supplying IPA, which is an example of a replacement liquid, to the upper surface of the substrate W to replace the pure water on the substrate W with the IPA is performed.

Specifically, in a state where at least one of the guards 24 is positioned at the upper position, the vertical actuator 54v lowers the shielding member 51 to an intermediate position between the upper position and the lower position. In this state, the replacement liquid valve 45 is opened, and the central nozzle 55 starts discharging IPA. Before the discharge of the IPA is started, the guard raising/lowering unit 27 may move at least one of the guards 24 vertically to switch the guard 24 that receives the liquid expelled from the substrate W.

The IPA discharged from the central nozzle 55 collides with the upper surface of the substrate W that is rotating at the replacement liquid supplying speed and thereafter flows outward along the upper surface of the substrate W due to a centrifugal force. The pure water on the substrate W is replaced by the IPA discharged from the central nozzle 55. A liquid film of the IPA that covers the entire upper surface of the substrate W is thereby formed. When a predetermined time elapses from when the replacement liquid valve 45 was opened, the replacement liquid valve 45 is closed and the discharge of the IPA is stopped. After the liquid film of the IPA covering the entire upper surface of the substrate W is formed, the substrate W may be rotated at a puddle speed (for example, a speed of more than 0 and less than or equal to 20 rpm) while stopping the discharge of the IPA from the central nozzle 55.

Next, a sublimable substance-containing liquid supplying step (step S8 in FIG. 7) of supplying a sublimable substance-containing liquid to the upper surface of the substrate W to form a liquid film of the sublimable substance-containing liquid covering the entire upper surface of the substrate W is performed.

Specifically, in a state where the shielding member 51 is positioned at the intermediate position and at least one of the guards 24 is positioned at the upper position, the sublimable substance-containing liquid valve 43 is opened, and the central nozzle 55 starts discharging the sublimable substance-containing liquid. Before the discharge of the sublimable substance-containing liquid is started, the guard raising/lowering unit 27 may move at least one of the guards 24 vertically to switch the guard 24 that receives the liquid expelled from the substrate W.

The sublimable substance-containing liquid discharged from the central nozzle 55 collides with the upper surface of the substrate W that is rotating at the sublimable substance supplying speed and thereafter flows outward along the upper surface of the substrate W due to a centrifugal force. The IPA on the substrate W is replaced by the sublimable substance-containing liquid discharged from the central nozzle 55. A liquid film of the sublimable substance-containing liquid that covers the entire upper surface of the substrate W is thereby formed. When a predetermined time elapses from when the sublimable substance-containing liquid valve 43 was opened, the sublimable substance-containing liquid valve 43 is closed, and the discharge of the sublimable substance-containing liquid is stopped.

Next, a film thickness decreasing step (step S9 in FIG. 7) of decreasing the film thickness (the thickness of the liquid film) of the sublimable substance-containing liquid on the substrate W while maintaining a state where the entire upper surface of the substrate W is covered with the liquid film of the sublimable substance-containing liquid by removing a portion of the sublimable substance-containing liquid on the substrate W is performed.

Specifically, in a state where the shielding member 51 is positioned at the intermediate position, the spin motor 14 maintains the rotational speed of the substrate W at the film thickness decreasing speed. The film thickness decreasing speed may be equal to or different from the sublimable substance supplying speed. The sublimable substance-containing liquid on the substrate W is expelled outward from the substrate W due to a centrifugal force even after the discharge of the sublimable substance-containing liquid is stopped. The thickness of the liquid film of the sublimable substance-containing liquid on the substrate W thus decreases. When the sublimable substance-containing liquid on the substrate W is expelled to some degree, an amount of the sublimable substance-containing liquid expelled from the substrate W per unit time decreases to zero or substantially zero. As a result, the thickness of the liquid film of the sublimable substance-containing liquid on the substrate W is stabilized at a value corresponding to the rotational speed of the substrate W.

Next, a solidified film forming step (step S10 in FIG. 7) of evaporating the solvent from the sublimable substance-containing liquid on the substrate W to form a solidified film SF (see FIG. 8B) containing the sublimable substance on the substrate W is performed.

Specifically, in a state where at least one of the guards 24 is positioned at the upper position, the vertical actuator 54v lowers the shielding member 51 to the lower position. At the same time as when or before or after the shielding member 51 reaches the lower position, the inert gas valve 64 is opened, and the central opening 61 of the shielding member 51 starts discharging the nitrogen gas. Further, at the same time as when or before or after the shielding member 51 reaches the lower position, the spin motor 14 increases the rotational speed of the substrate W from the film thickness decreasing speed to the solidified film forming speed. The solidified film forming speed may be equal to or different from the sublimable substance supplying speed.

When the rotation, etc., of the substrate W at the solidified film forming speed is started, the evaporation of the sublimable substance-containing liquid is promoted. Since the vapor pressure of the solvent is higher than the vapor pressure of the sublimable substance corresponding to the solute, the solvent evaporates at an evaporation rate higher than the evaporation rate of the sublimable substance. Therefore, the film thickness of the sublimable substance-containing liquid gradually decreases while the concentration of the sublimable substance gradually increases. When the freezing point of the sublimable substance-containing liquid coincides with the temperature of the sublimable substance-containing liquid, the sublimable substance-containing liquid starts to freeze, and the solidified film SF corresponding to a frozen body covering the entire upper surface of the substrate W is formed.

Next, a sublimating step of sublimating the solidified film SF on the substrate W to remove the solidified film SF from the upper surface of the substrate W is performed.

Specifically, sublimation of the solidified film SF is started (step S11 in FIG. 7), and an increase in humidity is started (step S12 in FIG. 7). Thereafter, the sublimation of the solidified film SF is finished (step S13 in FIG. 7), and the increase in humidity is stopped (step S14 in FIG. 7). Thereafter, the rotation of the substrate W and the shielding member 51 is stopped (step S15 in FIG. 7). Steps from step S11 in FIG. 7 to step S13 in FIG. 7 correspond to the sublimating step. Steps from step S12 in FIG. 7 to step S14 in FIG. 7 correspond to a humidity increasing step of increasing the humidity of the atmosphere in contact with the substrate W. Details on the sublimating step and the humidity increasing step will be described later.

Next, a carry-out step (step S16 in FIG. 7) of carrying out the substrate W from the chamber 4 is performed.

Specifically, the vertical actuator 54v raises the shielding member 51 to the upper position, and the guard raising/lowering unit 27 lowers all of the guards 24 to the lower position. Further, the inert gas valve 64 and the inert gas valve 84 are closed, and the central opening 61 of the shielding member 51 and the central opening 81 of the spin base 12 stop discharging the nitrogen gas. Thereafter, the center robot CR makes the hand Hc enter inside the chamber 4. After the plurality of chuck pins 11 release the gripping of the substrate W, the center robot CR supports the substrate W on the spin chuck 10 with the hand Hc. Thereafter, the center robot CR makes the hand Hc retreat from inside the chamber 4 while supporting the substrate W with the hand Hc. The processed substrate W is thereby carried out from the chamber 4.

Next, a phenomenon occurring on the front surface of the substrate W during a period from when the liquid film of the sublimable substance-containing liquid is changed into the solidified film SF to when the solidified film SF is removed will be described.

FIG. 8A to FIG. 8E are schematic cross-sectional views of the substrate W. FIGS. 8A to 8E each show a cross-section of the front surface of the substrate W on which the patterns P1 are formed. The substrate W before the patterns P1 are formed includes circular front and rear surfaces parallel to each other and an annular end surface connecting outer edges of the front and rear surfaces. The front surface and the rear surface of the substrate W are flat surfaces parallel to each other. The front surface of the substrate W is a device forming surface on which a device, such as a transistor, is formed. The rear surface of the substrate W is a non-device forming surface on which no device is formed. Both the front surface and the rear surface of the substrate W may be a device forming surface.

As shown in FIG. 8A, in the sublimable substance-containing liquid supplying step (step S8 in FIG. 7), a liquid film of the sublimable substance-containing liquid covering the entire front surface of the substrate W is formed. As shown in FIG. 8B, in the solidified film forming step (step S10 in FIG. 7), the sublimable substance-containing liquid on the substrate W is changed into the solidified film SF. FIG. 8B shows an example in which the thickness of the solidified film SF is larger than the height of the pattern P1. The thickness of the solidified film SF may be equal to or less than the height of the pattern P1. As shown in FIGS. 8B and 8C, in the sublimating step (steps S11 to S13 in FIG. 7), the solidified film SF is removed from the substrate W due to sublimation of the solidified film SF.

When the solidified film SF containing the sublimable substance is sublimated, a residue such as an organic substance may be generated from the solidified film SF. The black circles in FIGS. 8C and 8D represent organic substances. The circles in FIGS. 8C and 8D each merely represent an image of the organic substance, and the shape, etc., of the actual organic substance does not necessarily coincide with the shape, etc., of the organic substance shown in FIGS. 8C and 8D. FIGS. 8C and 8D show the substrate W from which all the solidified film SF is removed, but the organic substance is generated before all the solidified film SF is removed.

The organic substance may be a sublimable substance that has not sublimated or may be a substance in which the sublimable substance has been altered. The organic substance may be a substance with a sublimating property or a substance without a sublimating property. The organic substance may be an organic compound containing a hydrophilic group such as a carboxyl group, a hydroxyl group, or a sulfonic acid group or may be an organic compound containing no hydrophilic group. The organic substance may be at least one of cyclohexanone oxime, cyclohexanone, and caprolactam or may be an organic compound other than these.

As shown in FIG. 8D, in the humidity increasing step (steps S12 to S14 in FIG. 7), the humidity of the atmosphere in contact with the entire front surface of the substrate W is increased. The water molecules in the atmosphere in contact with the front surface of the substrate W are bonded to the organic substances on the substrate W generated from the solidified film SF. The water molecules in the atmosphere bonded to the organic substances are pushed by the gas stream flowing along the front surface of the substrate W and separated from the front surface of the substrate W. As shown in FIG. 8E, it is considered that the organic substances generated from the solidified film SF are removed by such a phenomenon repeatedly occurring in respective portions of the front surface of the substrate W. Actually, when the humidity of the atmosphere in contact with the substrate W was increased after the sublimation of the solidified film SF was started, it was confirmed that the residual amount of organic substances such as cyclohexanone oxime, cyclohexanone, and caprolactam was reduced.

The increase in the humidity of the atmosphere in contact with the substrate W starts after the sublimation of the solidified film SF starts. If the humidity is increased before the sublimation of the solidified film SF starts, moisture in the atmosphere may permeate the solidified film SF, and the sublimation of the solidified film SF may not start appropriately. When the humidity is increased while the liquid film of the sublimable substance-containing liquid is changed into the solidified film SF, moisture in the atmosphere may dissolve into the sublimable substance-containing liquid, and the time until the solidified film SF is formed may increase. If the humidity is increased after the sublimation of the solidified film SF starts, the possibility that such circumstances occur can be eliminated or reduced.

Before the sublimation of the solidified film SF ends, the increase in the humidity of the atmosphere in contact with the substrate W may be started after not less than half of the time from the start of the sublimation of the solidified film SF to the end of the sublimation of the solidified film SF elapses. In this way, since not less than half of the solidified film SF is sublimated, the organic substances can be removed while minimizing the influence of the increase in humidity on the sublimation of the solidified film SF. However, after the sublimation of the solidified film SF starts, the increase in humidity may be started before half of the time elapses. Although different from the example shown in FIG. 7, the increase in humidity may be started after the sublimation of the solidified film SF ends.

Next, a flow from the start of the sublimating step to the end of the humidity increasing step will be described.

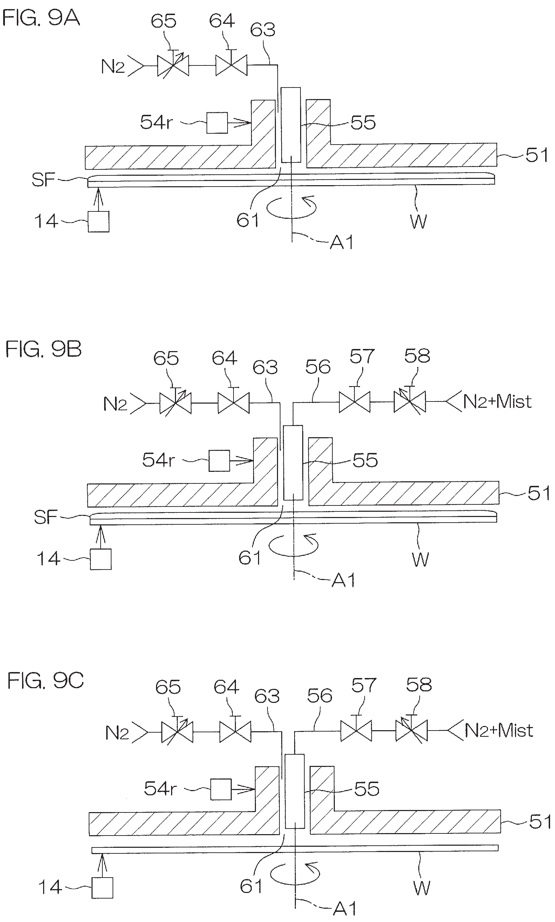

First, Flow 1, which is a first example of the flow from the start of the sublimating step to the end of the humidity increasing step, will be described. FIGS. 9A, 9B, and 9C are schematic views for explaining Flow 1. FIGS. 9A to 9C are views of the substrate W viewed horizontally.

When the solidified film SF is sublimated in Flow 1, as shown in FIG. 9A, in a state where the shielding member 51 is positioned at the lower position and the central opening 61 of the shielding member 51 discharges nitrogen gas downward, the spin motor 14 maintains the rotational speed of the substrate W at the sublimating speed, and the rotary actuator 54r maintains the rotational speed of the shielding member 51 at the sublimating speed.

When the rotation, etc., of the substrate W at the sublimating speed is started, the sublimation of the solidified film SF on the substrate W starts, and a gas containing the sublimable substance is generated from the solidified film SF on the substrate W. The gas (the gas containing the sublimable substance) generated from the solidified film SF radially flows in the space between the substrate W and the shielding member 51 and is expelled from above the substrate W. When a certain time elapses from the start of sublimation, as shown in FIG. 9C, all or almost all of the solidified film SF is removed from the substrate W. The sublimation of the solidified film SF thereby ends.

After the sublimation of the solidified film SF starts, in other words, after the rotational speed of the substrate W reaches the sublimating speed, as shown in FIG. 9B, the humidifying gas valve 57 is opened, and the central nozzle 55 (strictly speaking, the third tube 55c shown in FIG. 5) starts discharging the humidifying gas. At this time, the shielding member 51 is positioned at the lower position, and the substrate W and the shielding member 51 rotate at the sublimating speed. In addition, the central opening 61 of the shielding member 51 discharges the nitrogen gas downward. The inert gas valve 64 may be closed at the same time as when or before or after the central nozzle 55 starts discharging the humidifying gas.

The humidifying gas discharged from the central nozzle 55 flows radially in all directions from the center of the substrate W between the substrate W and the shielding member 51. A space between the substrate W and the shielding member 51 is thereby filled with the humidifying gas. While the humidifying gas is discharged, the humidity of the atmosphere in contact with the substrate W is maintained at a value higher than the humidity of the same atmosphere before the discharge of the humidifying gas is started. The organic substances generated due to the sublimation of the solidified film SF are removed from the substrate W by the supply of the humidifying gas. The sublimation of the solidified film SF proceeds even after the nitrogen gas between the substrate W and the shielding member 51 is replaced with the humidifying gas. Therefore, the organic substances can be removed while sublimating the solidified film SF.

When a predetermined time elapses from when the humidifying gas valve 57 was opened, the humidifying gas valve 57 is closed, and the central nozzle 55 stops discharging the humidifying gas. When the central opening 61 of the shielding member 51 is discharging the nitrogen gas, the inert gas valve 64 is also closed. After the humidifying gas valve 57 is closed, the carry-out step (step S16 in FIG. 7) is performed. All or almost all of the solidified film SF sublimates before the humidifying gas valve 57 is closed. Therefore, the organic substances remaining on the substrate W after all or almost all of the solidified film SF sublimates can also be removed by the humidifying gas.

Next, Flow 2, which is a second example of the flow from the start of the sublimating step to the end of the humidity increasing step, will be described.

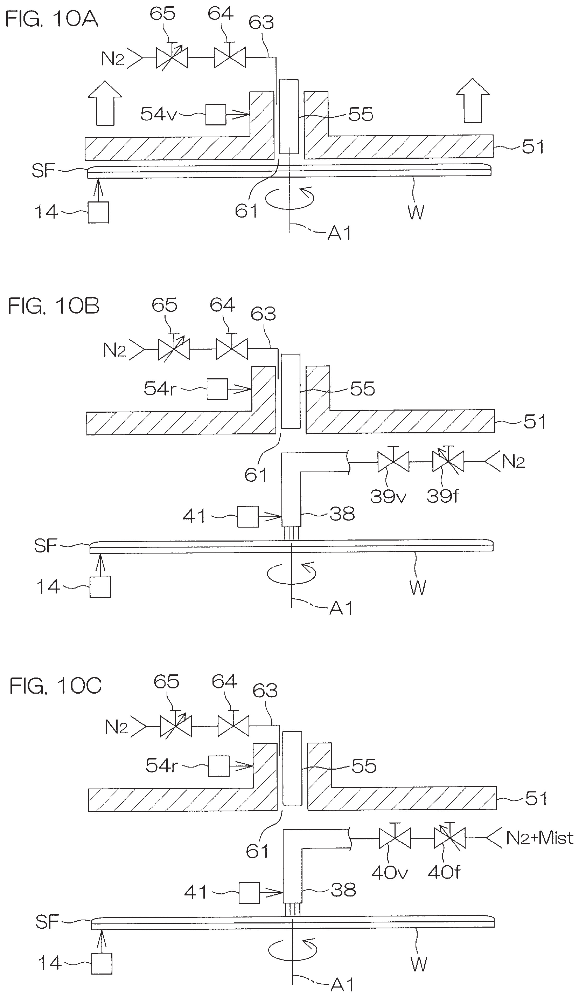

FIGS. 10A, 10B, and 10C are schematic views for explaining Flow 2. FIGS. 10A to 10C are views of the substrate W viewed horizontally. "The shielding member 51 discharges the nitrogen gas downward" in the following description means that the central opening 61 of the shielding member 51 discharges the nitrogen gas downward.

When the solidified film SF is sublimated in Flow 2, as shown in FIG. 10A, the vertical actuator 54v moves the shielding member 51 from the lower position to the upper position. Thereafter, as shown in FIG. 10B, the nozzle moving unit 41 moves the gas nozzle 38 positioned at the standby position to between the substrate W and the shielding member 51. Thereafter, the inert gas valve 39v is opened, and the gas nozzle 38 starts discharging the nitrogen gas. At the same time as when or before or after the gas nozzle 38 starts discharging the nitrogen gas, the spin motor 14 maintains the rotational speed of the substrate W at the sublimating speed, and the rotary actuator 54r maintains the rotational speed of the shielding member 51 at the sublimating speed.

When the rotation, etc., of the substrate W at the sublimating speed is started, sublimation of the solidified film SF on the substrate W is started. The nitrogen gas discharged downward from the gas nozzle 38 toward the solidified film SF promotes the sublimation of the solidified film SF. When the solidified film SF is sublimated, the nozzle moving unit 41 may keep the gas nozzle 38 still so that the collision position at which the nitrogen gas discharged from the gas nozzle 38 first collides with the upper surface of the substrate W is fixed at the central portion of the substrate W or may move the gas nozzle 38 horizontally so that the collision position passes through the central portion and the outer peripheral portion. The same applies to Flow 3 to be described later.

After the sublimation of the solidified film SF starts, as shown in FIG. 10C, in a state where the shielding member 51 is positioned at the upper position and the gas nozzle 38 is positioned between the substrate W and the shielding member 51, the humidifying gas valve 40v is opened, and the gas nozzle 38 starts discharging the humidifying gas. When the humidifying gas valve 40v is opened, the inert gas valve 39v may be closed or opened. The humidifying gas discharged downward from the gas nozzle 38 collides with the substrate W at the collision position in the upper surface of the substrate W and thereafter flows radially in all directions along the upper surface of the substrate W from the collision position.

The sublimation of the solidified film SF proceeds even after the humidity of the gas discharged from the gas nozzle 38 increases. The organic substances generated due to the sublimation of the solidified film SF are removed from the substrate W by the supply of the humidifying gas. When the gas nozzle 38 is discharging the humidifying gas, the nozzle moving unit 41 may keep the gas nozzle 38 still so that the collision position of the humidifying gas with respect to the upper surface of the substrate W is fixed at the central portion of the substrate W or may move the gas nozzle 38 horizontally so that the collision position of the humidifying gas passes through the central portion and the outer peripheral portion.

When a predetermined time elapses from when the humidifying gas valve 40v was opened, the humidifying gas valve 40v is closed, and the gas nozzle 38 stops discharging the humidifying gas. When the inert gas valve 64 and the inert gas valve 39v are opened, the inert gas valve 39v is also closed. All or almost all of the solidified film SF sublimates before the humidifying gas valve 40v is closed. At the same time as when or before or after the humidifying gas valve 40v is closed, the nozzle moving unit 41 moves the gas nozzle 38 to the standby position. Thereafter, the carry-out step (step S16 in FIG. 7) is performed. However, since the shielding member 51 is already positioned at the upper position, the raising of the shielding member 51 is omitted.

Next, Flow 3, which is a third example of the flow from the start of the sublimating step to the end of the humidity increasing step, will be described.

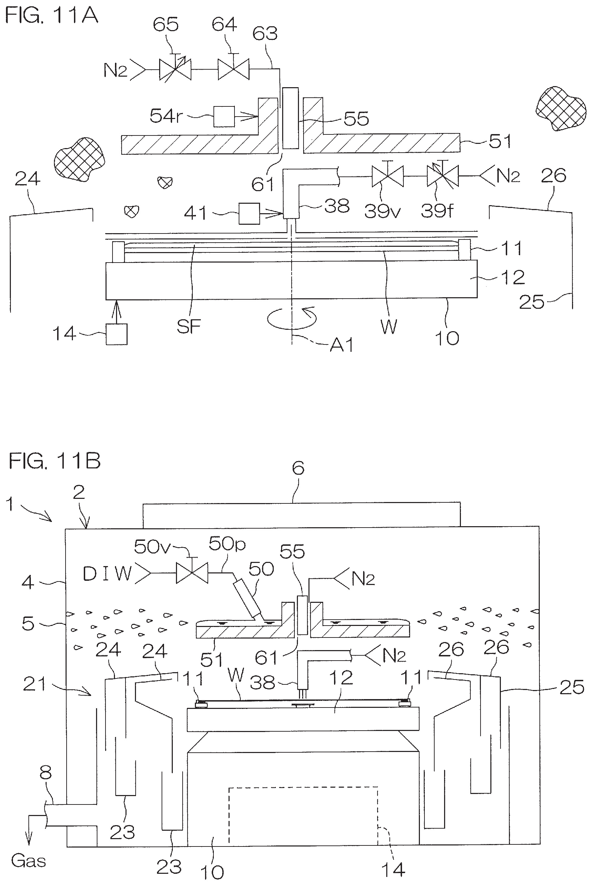

FIGS. 11A and 11B are schematic views for explaining Flow 3. FIGS. 11A to 11B are views of the substrate W viewed horizontally. A region indicated by cross hatching in FIG. 11A represents mist of the cleaning liquid.

When the solidified film SF is sublimated in Flow 3, the vertical actuator 54v (see FIG. 2) moves the shielding member 51 from the lower position to the upper position. Thereafter, as shown in FIG. 11A, the nozzle moving unit 41 moves the gas nozzle 38 positioned at the standby position to between the substrate W and the shielding member 51. Thereafter, the inert gas valve 39v is opened, and the gas nozzle 38 starts discharging the nitrogen gas. At the same time as when or before or after the gas nozzle 38 starts discharging the nitrogen gas, the spin motor 14 maintains the rotational speed of the substrate W at the sublimating speed, and the rotary actuator 54r maintains the rotational speed of the shielding member 51 at the sublimating speed.

After the sublimation of the solidified film SF starts, in other words, after the rotational speed of the substrate W reaches the sublimating speed, as shown in FIG. 11B, the cleaning liquid valve 50v is opened, and the cleaning liquid nozzle 50 starts discharging the cleaning liquid. At this time, the shielding member 51 is positioned at the upper position, and the substrate W and the shielding member 51 rotate at the sublimating speed. In addition, the gas nozzle 38 and the shielding member 51 discharge the nitrogen gas downward. After the sublimation of the solidified film SF starts, the humidifying gas may be discharged from at least one of the gas nozzle 38 and the central nozzle 55.

As shown in FIG. 11B, the cleaning liquid discharged from the cleaning liquid nozzle 50 collides with the upper surface of the rotating shielding member 51 and thereafter flows along the upper surface of the shielding member 51. Most of the cleaning liquid does not fall vertically or almost vertically from an outer circumference of the upper surface of the shielding member 51 but scatters almost horizontally from the upper surface of the shielding member 51. When the cleaning liquid collides with the shielding member 51, mist of the cleaning liquid is generated. The mist of the cleaning liquid is also generated when the cleaning liquid separates from the shielding member 51 and when the scattering cleaning liquid collides with an inner surface of the chamber 4. As a result, the humidity in the chamber 4 increases.

The clean air flowing downward from the FFU 6 applies a downward force to the mist of the cleaning liquid. The gas stream entering into the discharged gas duct 8 through the processing cup 21 applies a force to the mist of the cleaning liquid that moves it toward the discharged gas duct 8. The nitrogen gas discharged downward from the gas nozzle 38 toward the upper surface of the substrate W generates a force that attracts the mist of the cleaning liquid toward the upper surface of the substrate W. The mist of the cleaning liquid is supplied to the entire upper surface of the substrate W due to these forces. Accordingly, the organic substances generated due to the sublimation of the solidified film SF are removed from the substrate W by the supply of the humidifying gas.

When a predetermined time elapses from when the cleaning liquid valve 50v was opened, the cleaning liquid valve 50v is closed, and the cleaning liquid nozzle 50 stops discharging the cleaning liquid. At the same time as when or before or after the cleaning liquid valve 50v is closed, the inert gas valve 39v is closed, and the gas nozzle 38 stops discharging the nitrogen gas. Similarly, the inert gas valve 64 is closed, and the shielding member 51 stops discharging the nitrogen gas.

The nitrogen gas discharged from the gas nozzle 38 promotes evaporation of the mist of the cleaning liquid attached to the substrate W. The same applies to the nitrogen gas discharged from the shielding member 51. The gas stream generated by the rotation of the substrate W also promotes the evaporation of the mist of the cleaning liquid attached to the substrate W. Therefore, at least one of the gas nozzle 38 and the inert gas valve 64 may stop discharging the nitrogen gas after the cleaning liquid nozzle 50 stops discharging the cleaning liquid. Similarly, the spin motor 14 may stop the rotation of the substrate W after the cleaning liquid nozzle 50 stops discharging the cleaning liquid.

The nozzle moving unit 41 moves the gas nozzle 38 to the standby position at the same time as when or before or after the inert gas valve 39v is closed. Thereafter, the carry-out step (step S16 in FIG. 7) is performed. However, since the shielding member 51 is already positioned at the upper position, the raising of the shielding member 51 is omitted. Before the substrate W is carried out from the chamber 4, the shielding member 51 may be dried by high-speed rotation of the shielding member 51. For example, before the substrate W is carried out from the chamber 4, the substrate W and the shielding member 51 may be dried by rotating the substrate W at a high speed while rotating the shielding member 51 at a high speed.

Next, the advantages according to the embodiment will be described.

In the present embodiment, a liquid film of the sublimable substance-containing liquid containing the sublimable substance is formed on the front surface of the substrate W, and the liquid film is changed into the solidified film SF containing the sublimable substance. As a result, the solidified film SF containing the sublimable substance is formed on the front surface of the substrate W. Thereafter, the solidified film SF is sublimated and removed from the substrate W. When the solidified film SF is sublimated, organic substances may be generated from the solidified film SF. After the sublimation of the solidified film SF is started, the humidity of the atmosphere in contact with the substrate W is increased. As a result, water molecules in the atmosphere increase. The water molecules in the atmosphere are bonded to the organic substances and move the organic substances from the substrate W into the atmosphere. As a result, the organic substances remaining on the front surface of the substrate W can be reduced.

In the present embodiment, after the sublimation of the solidified film SF is started, a gas having a relatively high humidity is brought into contact with not only a portion of the front surface of the substrate W but also the entire front surface of the substrate W. The water molecules in the atmosphere contact the entire front surface of the substrate W. This makes it possible to increase the organic substances bonded to the water molecules floating in the atmosphere and to reduce the organic substances remaining on the front surface of the substrate W.

In the present embodiment, the increase in humidity is not started after the sublimation of the solidified film SF ends, but the increase in humidity is started before the sublimation of the solidified film SF ends. Therefore, as compared with the case where the increase in humidity is started after the sublimation of the solidified film SF ends, the time from the generation of the organic substances to the bonding of the organic substances with the water molecules in the atmosphere can be shortened. The bonding force between the organic substances and the substrate W may increase with the lapse of time. In such a case, the organic substances can be effectively removed from the substrate W.

In the present embodiment, a humidifying gas having humidity higher than that of the atmosphere in contact with the substrate W is discharged toward the front surface of the substrate W. As a result, the humidity of the atmosphere in contact with the substrate W can be increased, and water molecules in the atmosphere can be bonded to the organic substances attached to the substrate W. The humidifying gas collides with the front surface of the substrate W and thereafter flows along the front surface of the substrate W. The organic substances and the water molecules bonded to each other are quickly separated from the substrate W along with the flow of the humidifying gas. This makes it possible to reduce the organic substances reattached to the substrate W.

In the present embodiment, the shielding member 51 movable in parallel in a direction perpendicular to the front surface of the substrate W between the proximity position and the standby position is positioned at the proximity position. In this state, the humidifying gas is discharged toward the front surface of the substrate W. Therefore, as compared with the case where the humidifying gas is supplied to the front surface of the substrate W while the shielding member 51 is positioned at the standby position, the speed at which the humidifying gas flows along the front surface of the substrate W can be increased. By increasing the speed of the humidifying gas, the organic substances and the water molecules bonded to each other can be quickly removed from the substrate W.

In the present embodiment, the shielding member 51 movable in parallel in a direction perpendicular to the front surface of the substrate W between the proximity position and the standby position is positioned at the standby position. In this state, the humidifying gas is discharged toward the front surface of the substrate W. Since the shielding member 51 is further away from the substrate W as compared with the case where the shielding member 51 is positioned at the proximity position, the organic substances and the water molecules bonded to each other can be moved away from the substrate W in the direction perpendicular to the front surface of the substrate W. This makes it possible to reduce the organic substances reattached to the front surface of the substrate W.

In the present embodiment, after the sublimation of the solidified film SF is started, the humidifying gas is discharged from the gas nozzle 38, which is an example of the humidifying gas nozzle, toward the front surface of the substrate W in a state where the shielding member 51 is positioned at the standby position. In this state, the gas nozzle 38 is moved. When the gas nozzle 38 moves, the collision position where the humidifying gas first collides with the front surface of the substrate W also moves. As a result, the humidifying gas can directly collide with a wider area in the upper surface of the substrate W. Further, when the collision position of the humidifying gas approaches the organic substances and the water molecules bonded to each other, the force applied from the humidifying gas to the organic substances and the water molecules increases. Therefore, as compared with the case where the gas nozzle 38 is not moved, the organic substances remaining on the front surface of the substrate W can be further reduced.

In the present embodiment, the shielding member 51 is rotated while the shielding member 51 is positioned at the standby position. In this state, pure water is discharged from a position opposite to the substrate W with respect to the shielding member 51 toward the shielding member 51. The pure water collides with the shielding member 51. Mist is generated by this collision. Further, since the shielding member 51 rotates, the pure water scatters from the shielding member 51. This scattering generates mist. This makes it possible to easily create a large amount of mist in a short time. The mist flows toward the front surface of the substrate W in the atmosphere. Since the shielding member 51 is disposed at the standby position, the mist easily enters between the substrate W and the shielding member 51 as compared with the case where the shielding member 51 is disposed at the proximity position. As a result, the humidity of the atmosphere in contact with the substrate W can be increased.

In the present embodiment, a liquid film of the sublimable substance-containing liquid is changed into the solidified film SF while supplying the inert gas between the substrate W and the shielding member 51 in a state where the shielding member 51 is positioned at the proximity position. The inert gas flows between the substrate W and the shielding member 51. The gas stream toward the front surface of the substrate W is shielded by the shielding member 51. Therefore, the solidified film SF can be formed on the front surface of the substrate W while stabilizing the gas stream along the front surface of the substrate W. In addition, the speed at which the inert gas flows along the front surface of the substrate W can be increased as compared with the case where the inert gas is supplied to the front surface of the substrate W while the shielding member 51 is positioned at the standby position. By increasing the speed of the inert gas, the formation of the solidified film SF can be promoted.

In the present embodiment, a sublimable substance-containing liquid containing cyclohexanone oxime, which is an example of a sublimable substance, is supplied to the front surface of the substrate W and the solidified film SF containing cyclohexanone oxime is sublimated. When such a solidified film SF is sublimated, at least one of cyclohexanone oxime, cyclohexanone, and caprolactam may be generated as organic substances from the solidified film SF. When water molecules in the atmosphere approach such organic substances, the organic substances are bonded to the water molecules and are separated from the substrate W. Therefore, the organic substances remaining on the front surface of the substrate W can be reduced by increasing the humidity of the atmosphere in contact with the substrate W after the sublimation of the solidified film SF is started.

Next, other embodiments will be described.

The humidity of the atmosphere in contact with only a portion of the front surface of the substrate W may be increased instead of increasing the humidity of the atmosphere in contact with the entire front surface of the substrate W. For example, while a portion of the front surface of the substrate W is protected by at least one of the fluid and a tangible object, the humidifying gas may be discharged toward the remaining portion of the front surface of the substrate W.

After the sublimation of the solidified film SF ends, an increase in the humidity of the atmosphere in contact with the substrate W may be started. The increase in humidity may be ended before the sublimation of the solidified film SF ends.

After the humidity of the atmosphere in contact with the substrate W is increased, the humidity may be kept constant or may be changed. In the latter case, the humidity of the atmosphere in contact with the substrate W may be changed so that an increasing period or a decreasing period occurs or at least two of the increasing period, the decreasing period, and a constant period occur.

The increasing period is a period in which the humidity of the atmosphere in contact with the substrate W continuously increases with the lapse of time. The decreasing period is a period in which the humidity of the atmosphere in contact with the substrate W continuously decreases with the lapse of time. The constant period is a period in which the humidity of the atmosphere in contact with the substrate W is kept constant.

The gas nozzle 38 may be a mist nozzle that discharges a liquid such as water in a mist form or may be a shower nozzle that discharges a liquid in a shower form. The same applies to the central nozzle 55 (strictly speaking, the third tube 55c).

The mist nozzle may be a double-fluid nozzle of an external mixing type or an internal mixing type that generates mist by causing a liquid and a gas to collide with each other. The mist nozzle may be a spray nozzle that generates mist by discharging a compressed liquid from the orifice or by utilizing a Venturi effect.

Instead of discharging the nitrogen gas from the central opening 61 of the shielding member 51 and discharging the nitrogen gas containing atomized water, which is an example of the humidifying gas, from the central nozzle 55, the nitrogen gas containing atomized water may be discharged from the central opening 61 of the shielding member 51 and the nitrogen gas may be discharged from the central nozzle 55.

In Flow 1 described above, when the shielding member 51 is positioned at the lower position and the central nozzle 55 is discharging the humidifying gas toward the upper surface of the substrate W, a rinse liquid such as hot water may be discharged from the lower surface nozzle 71 toward the lower surface of the substrate W. After the sublimation of the solidified film SF ends, the substrate W may be dried by high-speed rotation of the substrate W in a state where the lower surface nozzle 71 does not discharge the rinse liquid.

The hot water discharged from the lower surface nozzle 71 collides with the lower surface of the rotating substrate W and thereafter flows outward along the lower surface of the substrate W. The substrate W is heated by hot water. This can prevent dew condensation from occurring on the upper surface of the substrate W. Further, since the humidifying gas flowing along the upper surface of the substrate W pushes the hot water that is trying to go around to the upper surface side of the substrate W through the end surface of the substrate W to the outside, it is possible to prevent the upper surface of the substrate W from getting wet with the hot water.

The substrate processing apparatus 1 is not restricted to an apparatus to process a disk-shaped substrate W, and may be an apparatus to process a polygonal substrate W.

Two or more arrangements among all the arrangements described above may be combined. Two or more steps among all the steps described above may be combined.

The embodiments of the present invention are described in detail above, however, these are just detailed examples used for clarifying the technical contents of the present invention, and the present invention should not be limitedly interpreted to these detailed examples, and the spirit and scope of the present invention should be limited only by the claims appended hereto.

## Claims

1. A substrate processing method comprising:
a liquid film forming step of supplying a sublimable substance-containing liquid containing a sublimable substance to a front surface of a substrate to form a liquid film of the sublimable substance-containing liquid on the front surface of the substrate;
a solidified film forming step of changing the liquid film of the sublimable substance-containing liquid into a solidified film containing the sublimable substance on the front surface of the substrate;
a sublimating step of sublimating the solidified film to remove the solidified film from the front surface of the substrate; and
a humidity increasing step of increasing humidity of an atmosphere in contact with the substrate after sublimation of the solidified film is started.

2. The substrate processing method according to claim 1, wherein the humidity increasing step includes a step of increasing humidity of an atmosphere in contact with an entirety of the front surface of the substrate after the sublimation of the solidified film is started.

3. The substrate processing method according to claim 1 or 2, wherein the humidity increasing step includes a step of increasing the humidity of the atmosphere in contact with the substrate after the sublimation of the solidified film is started and before the sublimation of the solidified film ends.

4. The substrate processing method according to claim 1, wherein the humidity increasing step includes a step of discharging a humidifying gas having humidity higher than that of the atmosphere in contact with the substrate toward the front surface of the substrate after the sublimation of the solidified film is started.

5. The substrate processing method according to claim 4, wherein the humidity increasing step includes a step of discharging the humidifying gas toward the front surface of the substrate in a state in which a shielding member that is movable in parallel in a direction perpendicular to the front surface of the substrate between a proximity position where the shielding member faces the front surface of the substrate and a standby position where the shielding member faces the front surface of the substrate at a position further away from the substrate than when the shielding member is positioned at the proximity position is positioned at the proximity position after the sublimation of the solidified film is started.

6. The substrate processing method according to claim 4, wherein the humidity increasing step includes a step of discharging the humidifying gas toward the front surface of the substrate in a state in which a shielding member that is movable in parallel in a direction perpendicular to the front surface of the substrate between a proximity position where the shielding member faces the front surface of the substrate and a standby position where the shielding member faces the front surface of the substrate at a position further away from the substrate than when the shielding member is positioned at the proximity position is positioned at the standby position after the sublimation of the solidified film is started.

7. The substrate processing method according to claim 6, wherein the humidity increasing step includes a step of moving a humidifying gas nozzle that discharges the humidifying gas toward the front surface of the substrate in a state where the shielding member is positioned at the standby position after the sublimation of the solidified film is started.

8. The substrate processing method according to claim 1, wherein the humidity increasing step includes a step of discharging water toward a shielding member from a position opposite to the substrate with respect to the shielding member while rotating the shielding member about a rotational axis passing through a central portion of the shielding member in a state in which the shielding member that is movable in parallel in a direction perpendicular to the front surface of the substrate between a proximity position where the shielding member faces the front surface of the substrate and a standby position where the shielding member faces the front surface of the substrate at a position further away from the substrate than when the shielding member is positioned at the proximity position is positioned at the standby position after the sublimation of the solidified film is started.

9. The substrate processing method according to any one of claims 5 to 8, wherein the solidified film forming step includes a step of changing the liquid film of the sublimable substance-containing liquid into the solidified film on the front surface of the substrate while supplying an inert gas between the substrate and the shielding member in a state where the shielding member is positioned at the proximity position.

10. The substrate processing method according to claim 1 or 2, wherein the sublimable substance is cyclohexanone oxime.

11. A substrate processing apparatus comprising:
a substrate holder that holds a substrate;
a sublimable substance-containing liquid nozzle that supplies a sublimable substance-containing liquid containing a sublimable substance to a front surface of the substrate held by the substrate holder and thereby forms a liquid film of the sublimable substance-containing liquid on the front surface of the substrate;
a gas nozzle that discharges a gas toward the front surface of the substrate held by the substrate holder;
a spin motor that rotates the substrate holder about a rotational axis passing through a central portion of the substrate held by the substrate holder and thereby rotates the substrate held by the substrate holder;
a humidifier that increases humidity of an atmosphere in contact with the substrate; and
a controller that causes at least one of the gas nozzle and the spin motor to perform at least one of supply of the gas to the substrate and rotation of the substrate and thereby changes the liquid film of the sublimable substance-containing liquid into a solidified film containing the sublimable substance on the front surface of the substrate, and then sublimates the solidified film, and causes the humidifier to increase the humidity of the atmosphere in contact with the substrate after sublimation of the solidified film is started.
